# EUROPEAN PATENT SPECIFICATION

(11) **EP 0 673 060 B1**
(45) Date of publication and mention of the grant of the patent: **12.02.2003**
(21) Application number: 95301735.7
(22) Date of filing: 15.03.1995
(51) Int. Cl.: H01L 21/50, H01L 21/52, H01L 21/00

(54) **Jig and manufacturing method for a semiconductor device**
Formbrett und Herstellungsverfahren für eine Halbleiteranordnung
Gabarit et procédé de fabrication pour un dispositif semi-conducteur

(30) Priority: 17.03.1994 JP 4625994; 15.02.1995 JP 2642195
(43) Date of publication of application: 20.09.1995
(73) Proprietor: FUJI ELECTRIC CO. LTD., Kawasaki 210 (JP)
(72) Inventor: Kirihata, Fumiaki, c/o Fuji Electric Co. Ltd., Kawasaki 210 (JP)
(74) Representative: Bridge-Butler, Alan James

(56) References cited:
- FR-A- 2 487 579
- US-A- 5 221 851
- US-A- 5 261 157
- PATENT ABSTRACTS OF JAPAN vol. 10, no. 309 (E-447) (2365) 21 October 1986 & JP-A-61 123 163 (MITSUBISHI) 11 June 1986

## Description

The present invention relates to soldering of an electrode plate and semiconductor chips incorporated in a flat type semiconductor modular device such as an insulated gate bipolar transistor (IGBT) module, a bipolar junction transistor (BJT) module, a MOS field effect transistor (MOSFET) module, a gate turnoff thyristor (GTO) module, a diode module, etc. These flat type semiconductor modular devices are used in electrical power converting apparatus such as inverters for industrial equipment, for automotive vehicles, etc.

So-called module structures which incorporate a plurality of semiconductor chips in a package have been adopted in increasing numbers as semiconductor devices to meet the recent market needs for large capacity semiconductor apparatus. In a MOS control device such as an IGBT, an emitter electrode and a gate electrode are usually arranged side by side on a first major surface of the semiconductor chip. This facilitates connecting a collector electrode, which is formed on the second major surface of the chip, to the exterior by soldering the IGBT chip onto a combination metal electrode and heat sink plate when the IGBT is mounted inside a package. However, the emitter electrode and the gate electrode cannot be soldered, since the emitter electrode and the gate electrode must be led to the exterior via individual terminals disposed on the first surface of the package. In the package assemblies of the prior art, the collector electrode is led out via the above described combination metal electrode and heat sink plate disposed on the second surface of the package, and the emitter electrode is led out via a terminal disposed on the first surface of the package. The emitter electrode is bonded to the emitter terminal using aluminium bonding wire of 300µm in diameter.

Though the above described package facilitates heat dissipation from the collector side, the package greatly limits the current capacity of the device, since heat is hardly radiated from the emitter side. The number of bonding wires connected to the emitter electrode increases as the current capacity increases, and can amount to several hundreds in a module package into which a plurality of IGBTs are incorporated. As the number of bonding wires increases, the internal wiring inductance also increases, which further causes large surges when the IGBT switches. Thus, the limited heat dissipation and increased wiring inductance prejudice the reliability of the semiconductor apparatus.

In another package which aims at solving the above described problems of limited heat dissipation and increased wiring inductance, IGBTs are incorporated inside a flat package like the flat type semiconductor devices, and the emitter electrodes and the collector electrodes are connected to the outside through area contacts with electrode plates exposed on the first and the second surfaces of the package. However, since the emitter electrode of the IGBT extends over and covers its gate electrode, although it is separated therefrom by an insulation layer, strain may be caused in the gate electrode when a single one of the electrode plates is pressed down in an entire chip area to be contacted with the emitter electrode. Therefore, this package has not been successfully used.

Japanese Patent Application No. H05-184271 (EP-A-0 637 080) describes a semiconductor device which includes a plurality of semiconductor chips each having a metal contact terminal located on a first face, a common electrode plate to which a second face of the semiconductor chip is attached and solder located respectively between the electrode plates and the second faces of each of the semiconductor chips. The specification described a MOS control device structure which is provided with a collector electrode acting both as a current path and for heat dissipation in place of the MOS structure on the emitter side. This MOS control device structure has been found to be effective, as it achieves pressure contact without exerting excessive pressure forces on the MOS control electrode.

However, it has been also found by experiments and simulations that the reliability, and the thermal and electrical properties may be badly affected when the thickness and flatness of the constituent elements, which include a plurality of semiconductor chips, are not confined within an extremely small tolerance,. since it is necessary to exert a uniform pressure on the semiconductor chips in order to achieve a uniform contact.

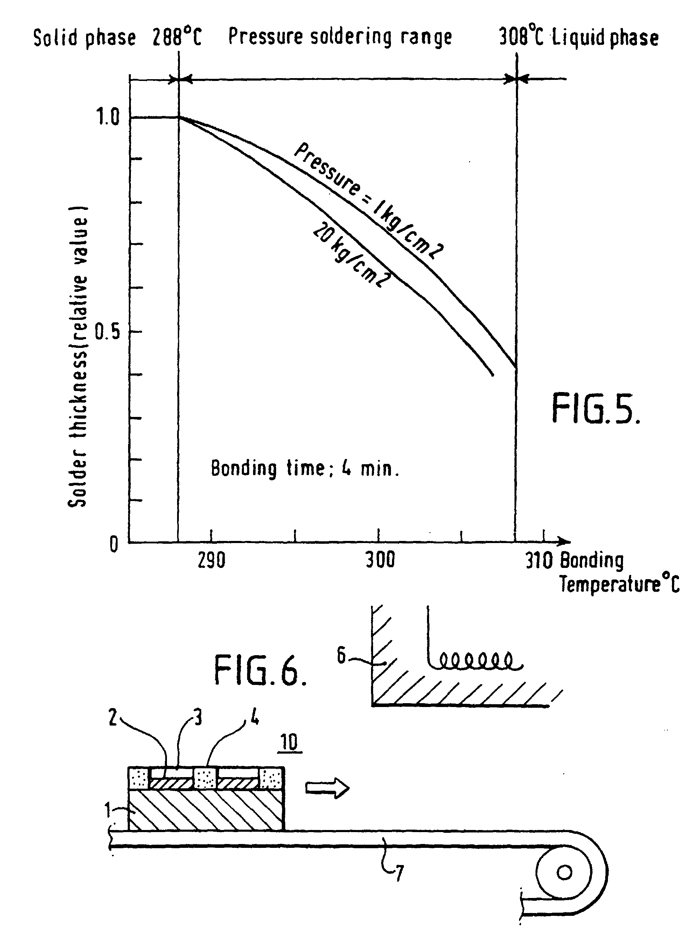

Figure 6 is a schematic sectional view showing a soldering method according to the prior art for soldering a common electrode plate onto the underside (the second surface) of a number of IGBTs. In Figure 6, a bonding assembly 10 includes a common electrode plate 1 of copper (Cu) or molybdenum (Mo) to which a surface treatment such as nickel (Ni) plating etc has been applied. Solder sheets 2 and semiconductor chips 3 are placed on the common electrode plate 1. On the rear or undersurface (the second surface) of the semiconductor chips 3 a surface treatment such as deposition of a gold (Au) layer or the like is applied. An assembly guide 4 serves to position the above described assembly elements accurately in relation to each other. The bonding assembly 10 is conveyed on a belt conveyor 7 into a soldering furnace 6.

The temperature of the soldering furnace 6 is controlled to a temperature above the melting point of the solder, and a reducing atmosphere is produced by a flow of nitrogen gas (N₂) or hydrogen gas (H₂) to prevent oxidation of the surfaces of the metal and the solder, and to maintain the surfaces of the metal and the solder in excellent condition for soldering. While the bonding assembly 10 is passing through the furnace 6, the solder fuses and the semiconductor chips 3 are bonded to the common electrode plate 1. After the bonding assembly 10 has cooled down, a semiconductor apparatus is manufactured by bonding aluminium (Al) wires to the surfaces of the semiconductor chips 3 for main current flow and gate control.

The soldering method of Figure 6 suffers from the following problems in obtaining flat type semiconductor modular devices:

Firstly, since the semiconductor chips are held on the common electrode plate only by their weight, the semiconductor chips may not lie flat but may be bonded obliquely due to the effects of surface tension in the molten solder. the difference in height of the opposite edges of a chip may be as much as the thickness of the solder sheet. Such obliquely bonded semiconductor chips may crack due to local stresses exerted to the chips when the chips are pressed down on to the electrode plate.

Secondly, if the pressure exerted on the chips when the semiconductor chips are pressed to solder the chips flat is too great, the molten solder may flow out from between the chip and the electrode plate.
In addition, since the soldering furnace is essentially an open tube and the reducing gas flows therethrough, the atmosphere in which soldering takes place may not be sufficiently controlled. If the soldering atmosphere is insufficiently reducing, unsoldered local areas may be caused (hereinafter simply referred to as "voids"). The voids may further cause deterioration in the electrical and thermal properties of the modular semiconductor devices.

In view of the foregoing, an object of the present invention is to provide a jig for manufacturing a modular semiconductor device and a method for manufacturing a modular semiconductor device using the jig which facilitates soldering a plurality of semiconductor chips flat down to a common electrode plate without causing any voids, and permits the pressing and contacting of the semiconductor chips having different chip thickness flat down to the common electrode plate.

According to a first aspect of the present invention a jig for manufacturing a semi-conductor device from a bonding assembly includes a plurality of semi-conductor chips each having a metal contact terminal located on a first face, a common electrode plate to which a second face of the semi-conductor chip is to be attached and sheets of solder located respectively between the electrode plates and the second faces of each of the semi-conductor chips, a pair of flat directly opposed isothermal plates means for heating said isothermal plates, enclosing means surrounding said isothermal plates and said bonding assembly, means for sealing said isothermal plates, heating means and body assembly within said enclosing means in a gas tight manner and to allow displacement of said isothermal plates to pressurise said contact terminals towards the common electrode plate.

The invention includes a method of manufacturing a semi-conductor device, including a plurality of semi-conductor chips having main electrode layers on a first and a second major faces thereof, using a jig, including heating means, a pair of isothermal plates fixed to said heating means, surrounded by an enclosing means, sealed in a gas tight manner by sealing means which allow movement of said heating means and said isothermal plates, the method thus comprises the steps:
a) sandwiching between said isothermal plates, a bonding assembly, including a common electrode plate common to said semi-conductor chips, sheets of solder placed on said common electrode plate corresponding to said semi-conductor chips, said semi-conductor chips placed on said solder and contact terminal plates placed on said semi-conductor chips,
b) filling said sealed enclosing means with a reducing gas,
c) heating said assembly with heating means to a predetermined temperature at which said solder dissociates into a combined liquid and solid phase; and
d) pressing said bonding assembly whereby said semi-conductor chips are bonded to said common electrode plate under pressure.

Preferably, the method includes the further step of placing second solder sheets between the semi-conductor chips and the contact terminal plates.

The predetermined temperature is preferably a temperature at which the solder dissociates to a liquid phase and a solid phase, that is, a temperature at which a liquid phase and a solid phase of the solder can coexist. Hereinafter, this temperature is referred to as the "two-phase coexisting temperature". Furthermore, it is preferable to use a solder which contains from 90.0 to 98.0 % by weight of lead and from 10 to 2.0 % by weight of tin.

By heating such a solder to a temperature at which it can sustain a two-phase state, the solder dissociates to a solid phase and a liquid phase. Since the solder is easily plastically deformed under pressure when in this state, the solder allows any variation in the position of the top surfaces of the constituent elements of the bonding assembly to be corrected, and ensures that the semi-conductor chips are bonded to the electrode plates and to the contact terminals under pressure. Since the bonding wires are eliminated, with the exception only of the bonding wire for connecting the gate electrode to the exterior, the internal wiring inductance is reduced. Since the positions of the tops of the contact terminals are levelled, even pressure is exerted on all the semi-conductor elements when a second, upper, contact plate is placed over the assembly to make electrical and thermal pressure contact with the semiconductor chips. The semi-conductor chips are thus prevented from cracking due to their upper surfaces being accurately arranged in a plane. And, since the semi-conductor chips are pressed vertically by a pair of common electrode plates and uniform contacts are established, the heat dissipation properties of the semi-conductor chips are improved.

The pressure bonding, conducted in a gastight enclosure filled with a reducing gas, prevents the bonding surfaces and the solder from oxidation, and expels voids from the contact planes. Due to this, the electrical and thermal properties of the semi-conductor devices are improved.

Also included within the invention is a method of producing a semi-conductor device comprising a common electrode plate formed with an array of grooves to receive an upstanding assembly guide the walls of which define multiple cells for the location of semi-conductor chips relative to the common electrode plate, a solder sheet being placed on the common electrode plate within each cell, a semi-conductor chip being placed on the solder sheet within each cell, and a clearance channel extending round the periphery of each cell and defined by an edge region of the solder sheet, by peripheral regions of the common electrode plate within each cell, and by the assembly guide, characterised in that the solder sheet is heated to a predetermined temperature while being deformed plastically into intimate contact with the central region of the common electrode plate within each cell and the semi-conductor chip, and solder material enters the clearance channel during such heating and deformation.

Embodiments of the invention will now be described in detail with reference to the accompanying drawings, in which:
Figure 1 is a sectional view showing a jig for manufacturing a semiconductor device according to the present invention;
Figure 2(a) shows an expanded sectional view of the bonding assembly of Figure 1 before pressure bonding;
Figure 2(b) shows the expanded sectional view of the bonding assembly after pressure bonding;
Figure 3 is a sectional view of an alternative arrangement of the relief channels;
Figure 4 is a sectional view of an alternative embodiment in which contact terminal blocks are bonded to the upper surfaces of the semiconductor chips;
Figure 5 is a graph showing the relation between the bonding temperature and the solder thickness with the applied pressure as a parameter; and,
Figure 6 is a sectional view schematically showing a soldering method according to the prior art;

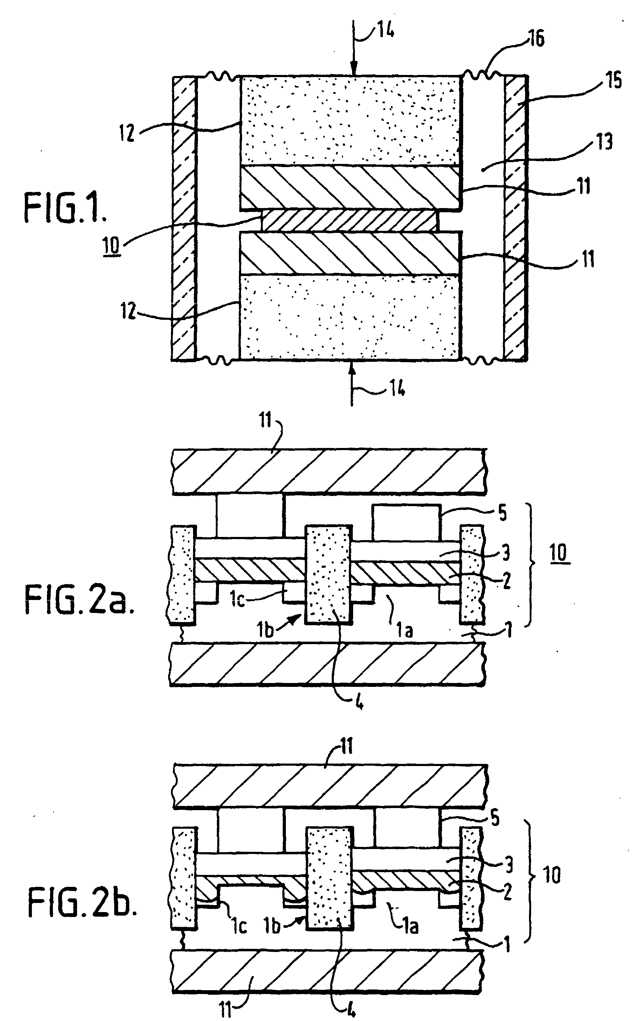

Figure 1 is a sectional view showing an embodiment of a jig for manufacturing a semiconductor device according to a first aspect of the present invention. As seen in Figure 1, the jig comprises a pair of brass isothermal plates 11 having flat and parallel faces. A pair of carbon heater plates 12 are in close thermal contact with the rear faces of the isothermal plates 11. A gastight chamber 13 is defined within a heat resistant glass case 15, and sealing means such as bellows 16 close the gap between the glass 15 and the heating plates 12 while allowing the heating plates 12 to move towards and away from each other, carrying the isothermal plates 11.

Figures 2(a) and 2(b) show the bonding assembly 10 of Figure 1 to an enlarged scale. As seen in Figure 2, the bonding assembly 10 includes a common electrode plate 1, on the upper surface of which are formed a number of raised areas 1a surrounded by grooves 1b. On each of the raised areas 1a a stack of components is formed by placing a respective solder sheet 2, a semi-conductor chip 3 and an upper contact terminal 5.

Between adjacent raised areas 1a are formed grooves 1b, into which assembly guides 4 are received, the walls of which define multiple cells for the location of the semi-conductor chips 3 relative to the electrode plate 1. The assembly guides 4 engage the sides of the semi-conductor chips 3, and prevent lateral movement of the chips 3 relative to the electrode 1. The grooves 1b are widened at their upper regions to form clearance channels 1c extending round each raised area la. The purpose of the clearance channels 1c will be described below.

An upper contact terminal 5 is placed on each chip 3. As is clear from the Figure, the manufacturing tolerances of the two stacks of components (the respective solder sheets 2, the semi-conductor chips 3, and the upper contact terminals 5) results in the height of the stack on the left-hand side being greater than that on the right.

The heater plates 12 are heated by high frequency induction, and the isothermal plates 11 are heated by the heat conducted from the heater plates 12. The isothermal plates 11, which are controlled over their entire surfaces to within a temperature deviation of ±1°C, heat the bonding assembly 10 uniformly, and heat the solder sheets 2 to a temperature at which solid and liquid phases of the solder coexist. The chamber 13 is kept gastight by the heat resistant glass case 15 and the sealing bellows 16, and to facilitate bonding of the assembly 10, a reducing atmosphere such as in N₂ etc. is maintained within the chamber 13. An O-ring or a pair of bellows or any suitable arrangement may be used for the sealing means 16.

With the assembly seen in Figure 2(a) at the correct temperature, the heater plates 12 and the isothermal plates 11 are urged together by a press represented by arrows 14, the faces of the isothermal plates 11 being held parallel.

As the isothermal plates 11 come closer together, the solder sheets plastically deform to ensure intimate contact between the electrode plate 1, the solder 2, and the lower surface of each semiconductor chip 3. Any solder which is squeezed out from between the electrode plate 1 and the lower surface of the semiconductor chip 3 is accommodated in the clearance area 1c, and thus excessive compressive forces on the chip 3 are avoided, and the chip 3 and the contact terminal 5 remain aligned with their upper surfaces in planes parallel to the isothermal plates 11.

As is clear from Figure 2(b), the height of the stack on the left hand side has been reduced to equal that of the right-hand stack, and the quantity of solder deformed into the clearance channel 1c is greater for the left-hand stack than for the right-hand stack.

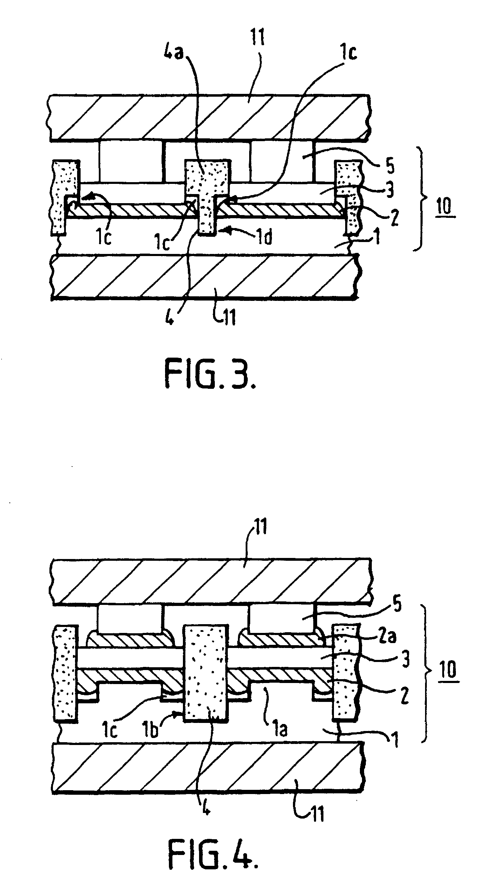

Figure 3 illustrates an alternative manner in which the clearance areas 1c may be formed. In this embodiment, the electrode plate 1 is formed with grooves 1d of constant width, and assembly jig sections 4 are held in the grooves 1d. The upper parts 4a of the assembly jig sections 4 are wider than the grooves 1d, and engage the sides of the semiconductor chips 3. Clearance channels 1c are thus formed beneath the overhung upper parts 4a of the assembly jig sections 4, and receive any solder which is squeezed out from between the electrode plate 1 and the lower surface of the semiconductor chip 3.

Figure 4 is a further embodiment of the invention, similar to that of Figures 2(a) and 2(b), but with a second solder sheet 2a interposed between the semiconductor chip 3 and the upper contact terminal 5. As heat and pressure are applied, the first and second solder sheets 2 and 2a deform to make intimate contacts, respectively, between the electrode plate 1 and the semiconductor chip 3, and the semiconductor chip 3 and the upper contact terminal 5. The upper surface of the contact terminals 5 remain in contact with the upper isothermic plate 11, preserving their coplanar alignment.

Figure 5 is a graph showing the relation between the bonding temperature and the solder thickness with the applied pressure as a parameter. The solder used contains 92.5 % by weight of lead (Pb), and 7.5 % by weight of tin (Sn). The two-phase coexisting temperature of this solder ranges between 288°C and 308°C. Figure 5 indicates that the height variation over the bonding assembly, caused by height variations of the upper contact terminals 5 and the semiconductor chips 3, can be compensated by the deformation under pressure of the molten solder at a temperature between 288°C and 308°C, that is in the two-phase coexisting temperature range, and using an applied pressure in the range between 1 kg/cm² and 20 kg/cm². A solder having a composition between 90.0 % by weight of Pb and 10.0 % by weight of Sn, and 98.0 % by weight of Pb and 2.0 % by weight of Sn may be used.

A soldering method which uses the jig of Figure 1 will be explained below.

As has been described, Figure 2(a) shows a sectional view of the main part of the bonding assembly before bonding, and Figure 2(b) is a sectional view of the main part of the bonding assembly after bonding. The bonding assembly 10 includes copper or molybdenum upper contact terminals 5; semiconductor chips 3 of an IGBT, a diode, etc.; solder sheets 2 containing 92.5 % by weight of Pb and 7.5 % by weight of Sn; and a common lower electrode plate 1 (on the second side of the semiconductor device). On the electrode plate 1, grooves 1b for positioning guides 4 and clearance channels 1c for accepting excessive solder at a time of bonding are formed.

The guides 4, the solder sheets 2, the semiconductor chips 3, and upper contact terminals 5 are placed one by one in the order of the description on the raised areas 1a of the common lower electrode plate 1. The bonding assembly 10 thus assembled is placed between the isothermal plates 11. The heater plates 12 are heated by high frequency induction so as to heat the bonding assembly 10 by conduction through the isothermal plates 11. The temperature of the bonding assembly 10 is controlled so as to be at a two-phase coexisting temperature for the solder of between 288°C and 308°C. As soon as the bonding assembly 10 is sufficiently heated, soldering is conducted by pressing the bonding assembly 10 with a press 14. The pressure of the press 14 is maintained between 1 kg/cm² and 20 kg/cm², and the temperature of the bonding assembly 10 is kept within the two-phase coexisting temperature range as indicated by Figure 5.

Each of the guides 4, the solder sheets 2, the semiconductor chip 3, and the common lower electrode plate 1 can be fabricated to a tolerance of ±5µm. However, the position of the top surface of the bonding assembly, i.e. the upper surface of the upper contact terminal 5, may vary at most by 40µm. Using the methods and apparatus of the prior art, it is difficult to press a plurality of semiconductor chips uniformly and to obtain excellent electrical and thermal properties, when such variation in the position of the top of the bonding assembly exists. In contrast to this, by maintaining the bonding assembly at a temperature at which the solder can exist in a two-phase state according to the present invention, the solder under the higher parts of the bonding assembly is more compressed so as that the upper surfaces of the individual stacks which make up the bonding assembly may be levelled as shown in Figure 2(b). By ensuring that the thinnest part of the bonding assembly down by 5µm or more, by controlling the pressure, the solder temperature, and the bonding temperature, a plurality of semiconductor chips may not only be provided with a uniform contact, but may also be bonded under pressure without causing any voids. Thus the present invention facilitates obtaining electrically and thermally excellent contact, and highly reliable modular semiconductor devices or semiconductor apparatus.

In this embodiment, the variation of the level of the top surfaces is reduced down from 40µm to less than 5µm by vertically pressing the bonding assembly with two flat parallel metal plates. Measurements on electrical characteristics and thermal resistance have confirmed that an excellent pressure contact is obtained by confining the height deviation within ±2.5µm. An ultrasonic examination has revealed that the present gastight bonding jig, which maintains an excellent reducing atmosphere, and the present bonding under pressure, which prevents voids from remaining, facilitate bonding of semiconductor elements without the formation of voids.

The present invention, which keeps the solder at its two-phase coexisting temperature and bonds a plurality of semiconductor chips under pressure with a common electrode plate, ensures that the semiconductor chips are simultaneously bonded flat down onto the common electrode plate without leaving any void. Thus, the present invention facilitates obtaining large capacity modular semiconductor devices which can be cooled from both sides through the pressure contacts.

## Claims

1. A jig for manufacturing a semi-conductor device from a bonding assembly which includes a plurality of semi-conductor chips (3) each having a metal contact terminal (5) located on a first face, a common electrode plate (1) to which a second face of the semi-conductor chip is to be attached and sheets of solder (2) located respectively between the electrode plates and the second faces of each of the semi-conductor chips (3),
a pair of flat directly opposed isothermal plates (11), means (12) for heating said isothermal plates (11), enclosing means (13) surrounding said isothermal plates (11) and said bonding assembly (10), means (16) for sealing said isothermal plates, heating means and body assembly (10) within said enclosing means (13) in a gas tight manner and to allow displacement of said isothermal plates (11) to pressurise said contact terminals (5) towards the common electrode plate (1).

2. A method of manufacturing a semi-conductor device, including a plurality of semi-conductor chips (3) having main electrode layers on a first and a second major faces thereof, using a jig, including heating means (12), a pair of isothermal plates (11) fixed to said heating means, surrounded by an enclosing means (13), sealed in a gas tight manner by sealing means (16) which allow movement of said heating means (12) and said isothermal plates (11), the method comprising the steps:
a) sandwiching between said isothermal plates (11), a bonding assembly (10), including a common electrode plate (1) common to said semi-conductor chips (3), sheets of solder (2) placed on said common electrode plate (1) corresponding to said semi-conductor chips (3), said semi-conductor chips (3) placed on said solder (2) and contact terminal plates (5) placed on said semi-conductor chips (3),
b) filling said sealed enclosing means (13) with a reducing gas,
c) heating said assembly (10) with heating means (12) to a predetermined temperature at which said solder dissociates into a combined liquid and solid phase; and
d) pressing said bonding assembly (10) whereby said semi-conductor chips (3) are bonded to said common electrode plate (1) under pressure.

3. A method as claimed in claim 2 or claim 3, including the further step of placing second solder sheets (2a) between the semi-conductor chips (3) and the contact terminal plates (5).

4. A method as claimed in claim 2, claim 3 or claim 4 wherein said predetermined temperature is from 288 to 308 degrees Celsius.

5. A method as claimed in claims 2 - 4 wherein said solder (2) comprises from 90.0 to 98.0 % by weight of lead and from 10 to 2.0 % by weight of tin.

6. A method according to claims 2 to 5 **characterised in that** a clearance channel (1c) is provided between the common electrode plate (1) and each semi-conductor chip (3) to accommodate solder (2) exuded from between the semi-conductor chip (3) and the corresponding contact area (1a) of the common electrode plate (1).

7. A method according to claims 2 to 6 **characterised in that** a clearance channel (1c) is provided by forming the common electrode plate (1) with a raised area (1a) corresponding in shape to each semi-conductor chip (3) and surrounded by a respective clearance channel (1c).

8. A method according to any of claims 2 to 6 **characterised in that** the clearance channel (1c) is provided by forming guides (4) with a respective clearance channel (1d) surrounding each semi-conductor chip (3).

9. A method according to any of claims 2 to 8, **characterised in that** the common electrode plate is formed from molybdenum (Mo).

10. A method according to any of claims 2 to 9, **characterised in that** the semi-conductor chips are IGBTs.

11. A method according to any of claims 2 to 10, **characterised in that** the pressure is in the range of from 1 to 20 kg/cm².

12. A method as claimed in any one of the preceding claims 2 to 11 for producing a semi-conductor device comprising a common electrode plate (1) formed with an array of grooves (1b) to receive an upstanding assembly guide (4) the walls of which define multiple cells for the location of semi-conductor chips (3) relative to the common electrode plate (1), a solder sheet (2) being placed on the common electrode plate (1) within each cell, a semi-conductor chip (3) being placed on the solder sheet (2) within each cell, and a clearance channel (1c) extending round the periphery of each cell and defined by an edge region of the solder sheet (2), by peripheral regions of the common electrode plate (1) within each cell, and by the assembly guide (4), **characterised in that** the solder sheet (2) is heated to a predetermined temperature while being deformed plastically into intimate contact with the central region of the common electrode plate (1) within each cell and the semi-conductor chip (3), and solder material enters the clearance channel (1c) during such heating and deformation.

13. A method according to claim 12, **characterised in that** the lower electrode plate (1) has a raised central area (1a) within each cell, and the clearance channel (1c) surrounds the raised central area (1a).

14. A method according to claim 12, **characterised in that** the clearance channel (1c) is formed as an undercut (1d) in the upstanding part of the assembly guide (4) defining each of the cells.

15. A method according to any of claims 12 to 14, **characterised by** including the further step of placing second solder sheets (2a) between the semi-conductor chips (3) and the contact terminal plates (5) prior to the heating and deformation of the solder sheets (2, 2a).

## Patentansprüche

1. Formbrett zur Herstellung eines Halbleiterbauelements aus einer Bondanordnung, die eine Vielzahl von Halbleiterchips (3), die jeweils einen Metallkontaktanschluß (5) aufweisen, der sich auf einer ersten Fläche befindet, eine gemeinsame Elektrodenplatte (1), an der eine zweite Fläche des Halbleiterchips befestigt werden soll, und Schichten aus Lötmittel (2), die sich jeweils zwischen den Elektrodenplatten und den zweiten Flächen von jedem der Halbleiterchips (3) befinden, umfaßt, aus einem Paar von ebenen, direkt entgegengesetzten isothermischen Platten (11), einer Einrichtung (12) zum Heizen der isothermischen Platten (11), einer Einschlußeinrichtung (13), die die isothermischen Platten (11) und die Bondanordnung (10) umgibt, einer Einrichtung (16) zum Abdichten der isothermischen Platten, der Heizeinrichtung und der Bondanordnung (10) innerhalb der Einschlußeinrichtung (13) in einer gasdichten Weise, und um eine Verschiebung der isothermischen Platten (11) zu ermöglichen, um die Kontaktanschlüsse (5) in Richtung der gemeinsamen Elektrodenplatte (1) unter Druck zu setzen.

2. Verfahren zur Herstellung eines Halbleiterbauelements mit einer Vielzahl von Halbleiterchips (3) mit Hauptelektrodenschichten auf einer ersten und einer zweiten Hauptfläche derselben unter Verwendung einer Formplatte mit einer Heizeinrichtung (12), einem Paar von isothermischen Platten (11), die an der Heizeinrichtung befestigt sind, von einer Einschlußeinrichtung (13) umgeben sind, in einer gasdichten Weise durch eine Dichtungseinrichtung (16) abgedichtet sind, die eine Bewegung der Heizeinrichtung (12) und der isothermischen Platten (11) ermöglicht, wobei das Verfahren die Schritte umfaßt:
a) Einfügen, zwischen den isothermischen Platten (11), einer Bondanordnung (10) mit einer gemeinsamen Elektrodenplatte (1), die für die Halbleiterchips (3) gemeinsam sind, Schichten von Lötmittel (2), die auf der gemeinsamen Elektrodenplatte (1) entsprechend den Halbleiterchips (3) angeordnet sind, wobei die Halbleiterchips (3) auf dem Lötmittel (2) angeordnet sind und Kontaktanschlußplatten (5) auf den Halbleiterchips (3) angeordnet sind,
b) Füllen der abgedichteten Einschlußeinrichtung (13) mit einem reduzierenden Gas,
c) Heizen der Anordnung (10) mit der Heizeinrichtung (12) auf eine vorbestimmte Temperatur, bei der sich das Lötmittel in eine kombinierte flüssige und feste Phase zersetzt; und
d) Drücken der Bondanordnung (10), wobei die Halbleiterchips (3) unter Druck an die gemeinsame Elektrodenplatte (1) gebondet werden.

3. Verfahren nach Anspruch 2 oder Anspruch 3 mit dem weiteren Schritt des Anordnens von zweiten Lötmittelschichten (2a) zwischen den Halbleiterchips (3) und den Kontaktanschlußplatten (5).

4. Verfahren nach Anspruch 2, Anspruch 3 oder Anspruch 4, wobei die vorbestimmte Temperatur 288 bis 308 Grad Celsius beträgt.

5. Verfahren nach den Ansprüchen 2 - 4, wobei das Lötmittel (2) 90,0 bis 98,0 Gewichts-% Blei und 10 bis 2,0 Gewichts-% Zinn enthält.

6. Verfahren nach den Ansprüchen 2 bis 5, **dadurch gekennzeichnet, daß** ein Abstandskanal (1c) zwischen der gemeinsamen Elektrodenplatte (1) und jedem Halbleiterchip (3) vorgesehen wird, um Lötmittel (2) aufzunehmen, das zwischen dem Halbleiterchip (3) und der entsprechenden Kontaktfläche (1a) der gemeinsamen Elektrodenplatte (1) ausgeschieden wird.

7. Verfahren nach den Ansprüchen 2 bis 6, **dadurch gekennzeichnet, daß** ein Abstandskanal (1c) durch Ausbilden der gemeinsamen Elektrodenplatte (1) mit einem erhabenen Bereich (1a), der in der Form jedem Halbleiterchip (3) entspricht und von einem jeweiligen Abstandskanal (1c) umgeben ist, bereitgestellt wird.

8. Verfahren nach einem der Ansprüche 2 bis 6, **dadurch gekennzeichnet, daß** der Abstandskanal (1c) durch Ausbilden von Führungen (4) bereitgestellt wird, wobei ein jeweiliger Abstandskanal (1d) jeden Halbleiterchip (3) umgibt.

9. Verfahren nach einem der Ansprüche 2 bis 8, **dadurch gekennzeichnet, daß** die gemeinsame Elektrodenplatte aus Molybdän (Mo) ausgebildet wird.

10. Verfahren nach einem der Ansprüche 2 bis 9, **dadurch gekennzeichnet, daß** die Halbleiterchips IGBTs sind.

11. Verfahren nach einem der Ansprüche 2 bis 10, **dadurch gekennzeichnet, daß** der Druck im Bereich von 1 bis 20 kg/cm² liegt.

12. Verfahren nach einem der vorangehenden Ansprüche 2 bis 11 zur Herstellung eines Halbleiterbauelements mit einer gemeinsamen Elektrodenplatte (1), die mit einer Anordnung von Nuten (1b) ausgebildet wird, um eine aufrecht stehende Anordnungsführung (4) aufzunehmen, deren Wände mehrere Zellen für die Anordnung von Halbleiterchips (3) relativ zur gemeinsamen Elektrodenplatte (1) definieren, einer Lötmittelschicht (2), die auf der gemeinsamen Elektrodenplatte (1) innerhalb jeder Zelle angeordnet wird, einem Halbleiterchip (3), der auf der Lötmitteischicht (2) innerhalb jeder Zelle angeordnet wird, und einem Abstandskanal (1c), der sich um den Umfang jeder Zelle erstreckt und durch einen Kantenbereich der Lötmittelschicht (2), durch Umfangsbereiche der gemeinsamen Elektrodenplatte (1) innerhalb jeder Zelle, und durch die Anordnungsführung (4) definiert ist, **dadurch gekennzeichnet, daß** die Lötmittelschicht (2) auf eine vorbestimmte Temperatur erhitzt wird, während sie plastisch in einen innigen Kontakt mit dem mittleren Bereich der gemeinsamen Elektrodenplatte (1) innerhalb jeder Zelle und mit dem Halbleiterchip (3) verformt wird, und das Lötmaterial in den Abstandskanal (1c) während eines solchen Erhitzens und einer solchen Verformung eintritt.

13. Verfahren nach Anspruch 12, **dadurch gekennzeichnet, daß** die untere Elektrodenplatte (1) einen erhabenen mittleren Bereich (1a) innerhalb jeder Zelle aufweist und der Abstandskanal (1c) den erhabenen mittleren Bereich (1a) umgibt.

14. Verfahren nach Anspruch 12, **dadurch gekennzeichnet, daß** der Abstandskanal (1c) als Unterätzung (1d) im aufrecht stehenden Teil der Anordnungsführung (4), die jede der Zellen definiert, ausgebildet wird.

15. Verfahren nach einem der Ansprüche 12 bis 14, **dadurch gekennzeichnet, daß** es den weiteren Schritt des Anordnens von zweiten Lötmittelschichten (2a) zwischen den Halbleiterchips (3) und den Kontaktanschlußplatten (5) vor dem Heizen und der Verformung der Lötmittelschichten (2, 2a) umfaßt.

## Revendications

1. Gabarit pour fabriquer un dispositif à semi-conducteurs à partir d'un assemblage d'interconnexions qui inclut une pluralité de puces à semi-conducteurs (3) ayant chacune une borne de contact métallique (5) située sur une première face, une plaque à électrodes commune (1) à laquelle une seconde face de la puce à semi-conducteurs doit être fixée et des plaques de métal d'apport de brasage (2) situées respectivement entre les plaques à électrodes et les secondes faces de chacune des puces à semi-conducteurs (3), une paire de plaques isothermes plates (11) directement opposées, des moyens (12) pour chauffer lesdites plaques isothermes (11), des moyens englobants (13) entourant lesdites plaques isothermes (11) et ledit assemblage d'interconnexions (10), des moyens (16) pour rendre étanches lesdites plaques isothermes, chauffer les moyens et l'assemblage d'interconnexions (10) à l'intérieur desdits moyens englobants (13) d'une manière étanche aux gaz et pour permettre le déplacement desdites plaques isothermes (11) afin de presser lesdites bornes de contact (5) contre la plaque à électrodes commune (1).

2. Procédé de fabrication d'un dispositif à semi-conducteurs, incluant une pluralité de puces à semi-conducteurs (3) ayant des couches d'électrodes principales sur une première et une seconde face principale de celles-ci, utilisant un gabarit, incluant des moyens de chauffage (12), une paire de plaques isothermes (11) fixées aux dits moyens de chauffage, entourées par des moyens englobants (13), rendus étanches d'une manière étanche aux gaz par des moyens d'étanchéité (16) qui permettent le déplacement desdits moyens de chauffage (12) et deadites plaques isothermes (11), le procédé comprenant les étapes consistant à :
a) disposer en sandwich entre lesdites plaques isothermes (11), un assemblage d'interconnexions (10), incluant une plaque à électrodes commune (1) commune aux dites puces à semi-conducteurs (3), des plaques d'apport de brasage (2) placées sur ladite plaque à électrodes commune (1) correspondant aux dites puces à semi-conducteurs (3), lesdites puces à semi-conducteurs (3) placées sur ledit métal d'apport de brasage (2) et des plaques à bornes de contact (5) placées sur lesdites puces à semi-conducteurs (3),
b) remplir lesdits moyens englobants rendus étanches (13) avec un gaz réducteur,
c) chauffer ledit assemblage (10) avec des moyens de chauffage (12) à une température prédéterminée à laquelle ledit métal d'apport de brasage se dissocie en une phase liquide et solide combinée et
d) comprimer ledit assemblage d'interconnexions (10), lesdites puces à semi-conducteurs (3) étant interconnectées à ladite plaque à électrodes commune (1) sous pression.

3. Procédé selon la revendication 2 ou la revendication 3, incluant l'étape supplémentaire consistant à placer des secondes plaques d'apport de brasage (2a) entre les puces à semi-conducteurs (3) et les plaques des bornes de contact (5).

4. Procédé selon la revendication 2, la revendication 3 ou la revendication 4, dans lequel ladite température prédéterminée va de 288 à 308 degrés Celsius.

5. Procédé selon les revendications 2 à 4, dans lequel ledit métal d'apport de brasage (2) comprend de 90,0 à 98,0 % en poids de plomb et de 10 à 2,0 % en poids d'étain.

6. Procédé selon les revendications 2 à 5, **caractérisé en ce qu'**un canal de dégagement (1c) est réalisé entre la plaque à électrodes commune (1) et chaque puce à semi-conducteurs (3) pour loger le métal d'apport de brasage (2) exsudé d'entre la puce à semi-conducteurs (3) et la zone de contact correspondante (1a) de la plaque à électrodes commune (1)

7. procédé selon lea revendications 2 à 6, **caractérisé en ce qu'**un canal de dégagement (1c) est réalisé en constituant la plaque à électrodes commune (1) avec une zone dressée (1a) correspondant en forme à chaque puce à semi-conducteurs (3) et entourée par un canal de dégagement respectif (1c).

8. Procédé selon l'une quelconque des revendications 2 à 6, **caractérisé en ce que** le canal de dégagement (1c) est réalisé en formant des dispositifs de guidage (4) avec un canal de dégagement respectif (1d) entourant chaque puce à semi-conducteurs (3).

9. procédé selon l'une quelconque des revendications 2 à 8, **caractérisé en ce que** la plaque à électrodes commune est constituée de molybdène (Mo).

10. Procédé selon l'une quelconque des revendications 2 à 9, **caractérisé en ce que** les puces à semi-conducteurs sont des IGBTs.

11. Procédé selon l'une quelconque des revendications 2 à 10, **caractérisé en ce que** la pression est comprise dans la gamme de 1 à 20 kg/cm².

12. Procédé selon l'une quelconque des revendications précédentes 2 à 11 pour produire un dispositif à semi-conducteurs comprenant une plaque à électrodes commune (1) constituée d'une rangée de rainures (1b) pour recevoir un dispositif de guidage d'assemblage droit (4), dont les parois définissent des cellules multiples pour le placement de puces à semi-conducteurs (3) par rapport à la plaque à électrodes commune (1), une plaque de métal d'apport de brasage (2) étant placée sur la plaque à électrodes commune (1) à l'intérieur de chaque cellule, une puce à semi-conducteurs (3) étant placée sur la plaque de métal d'apport de brasage (2) à l'intérieur de chaque cellule et un canal de dégagement (1c) s'étendant autour de la périphérie de chaque cellule et défini par une région de lisière de la plaque de métal d'apport de brasage (2), par des régions périphériques de la plaque à électrodes commune (1) à l'intérieur de chaque cellule et par le dispositif de guidage d'assemblage (4), **caractérisé en ce que** la plaque de métal d'apport de brasage (2) est chauffée à une température prédéterminée tout en étant déformée plastiquement en contact intime avec la région centrale de la plaque à électrodes commune (1) à l'intérieur de chaque cellule et la puce à semi-conducteurs (3) et que le matériau du métal d'apport de brasage pénètre dans le canal de dégagement (1c) durant un tel chauffage et une telle déformation.

13. Procédé selon la revendication 12, **caractérisé en ce que** la plaque à électrodes inférieure (1) a une zone centrale dressée (1a) à l'intérieur de chaque cellule et que le canal de dégagement (1c) entoure la zone centrale dressée (1a).

14. Procédé selon la revendication 12, **caractérisé en ce que** le canal de dégagement (1c) est constitué comme un évidemment (1d) dans la partie droite du dispositif de guidage d'assemblage (4) définissant chacune de cellules.

15. Procédé selon l'une quelconque des revendications 12 à 14, **caractérisé par le fait qu'**il inclut l'étape supplémentaire consistant à placer des secondes plaques de métal d'apport de brasage (2a) entre les puces à semi-conducteurs (3) et les plaques de bornes de contact (5) avant le chauffage et la déformation des plaques de métal d'apport de brasage (2, 2a).
